(19) Europäisches Patentamt
European Patent Office
Office européen des brevets

(11) **EP 2 301 150 B1**

(12) **FASCICULE DE BREVET EUROPEEN**

(45) Date de publication et mention
de la délivrance du brevet:
**03.07.2019 Bulletin 2019/27**

(21) Numéro de dépôt: **09769499.6**

(22) Date de dépôt: **29.05.2009**

(51) Int Cl.:
*H03H 9/02* *(2006.01)* *H03H 9/17* *(2006.01)*

(86) Numéro de dépôt international:
**PCT/FR2009/051011**

(87) Numéro de publication internationale:
**WO 2009/156658 (30.12.2009 Gazette 2009/53)**

(54) **RESONATEUR HBAR A STABILITE EN TEMPERATURE ELEVEE**

HBAR RESONATOR MIT ERHÖHTER TEMPERATUR-STABILITÄT

HBAR RESONATOR WITH INCREASED TEMPERATURE STABILITY

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **04.06.2008 FR 0853689**

(43) Date de publication de la demande:
**30.03.2011 Bulletin 2011/13**

(73) Titulaires:
• **Centre National de la Recherche Scientifique (C.N.R.S.)**
**75016 Paris (FR)**
• **Université de Franche-Comté**
**25030 Besançon Cedex (FR)**

(72) Inventeurs:
• **BALLANDRAS, Sylvain**
**F-25000 Besançon (FR)**
• **GACHON, Dorian**
**F-66750 Saint Cyprien (FR)**

(74) Mandataire: **Lavoix**
**2, place d'Estienne d'Orves**
**75441 Paris Cedex 09 (FR)**

(56) Documents cités:
**US-A- 3 401 275**

• **MCAVOY B R ET AL: "Highly stable, ovenized bulk shear mode resonators" PROCEEDINGS OF THE ANNUAL FREQUENCY CONTROL SYMPOSIUM. PHILADELPHIA, MAY 29 - 31 1985. MAY 29 - 31, 1985; [PROCEEDINGS OF THE ANNUAL FREQUENCY CONTROL SYMPOSIUM], NEW YORK, IEEE, US, vol. SYMP. 39, 31 mai 1985 (1985-05-31), pages 372-374, XP008090791**
• **KLINE G R ET AL: "Overmoded high Q resonators for microwave oscillators" FREQUENCY CONTROL SYMPOSIUM, 1993. 47TH., PROCEEDINGS OF THE 1993 IEEE INTERNATIONAL SALT LAKE CITY, UT, USA 2-4 JUNE 1993, NEW YORK, NY, USA,IEEE, 2 juin 1993 (1993-06-02), pages 718-721, XP010126168**

**EP 2 301 150 B1**

**Description**

L'invention se rapporte à un résonateur de type à ondes de volumes à modes harmoniques élevés (HBAR en anglais pour Harmonic Bulk Acoustic Resonator) ayant une stabilité en température élevée, à un procédé de fabrication correspondant, à un oscillateur et à un filtre comportant au moins un tel résonateur.

De tels résonateurs électro-acoustiques sont utilisés pour la stabilisation en température des oscillateurs électriques ainsi que pour de nombreuses applications de traitement de signal (filtrage à sélectivité élevée, détection en bande étroite, codage etc.) à base de composants passifs dans la gamme 50 MHz - 20 GHz.

Ces dispositifs sont optimisés pour leurs applications particulières en cherchant à maximiser leurs coefficients de qualité ou de couplage par exemple.

Il est en général difficile de trouver des structures offrant un bon compromis entre fort couplage électro-mécanique, fort coefficient de qualité et stabilité thermique.

De nombreuses solutions fondées sur les ondes de surface (SAW en anglais pour Surface Acoustic Wave) pour des applications à des fréquences pouvant aller jusqu'à 2,5 GHz permettent de minimiser la dérive thermique de la fréquence des résonateurs mais rarement de l'annuler complètement.

En ondes de volume, l'utilisation du quartz comme transducteur piézoélectrique ayant une stabilité en fréquence élevée est connue mais reste limitée à des fréquences inférieures à 100 MHz.

En ondes de volume, l'utilisation d'une couche d'aluminium nitruré (AIN) comme transducteur a permis le développement de résonateurs dans la gamme 50 MHz - 20 GHz. Ainsi, le document intitulé « Thin Film Resonators and Filters » de .M. Lakin publié dans 1999 IEEE Ultrasonics Symposium » décrit un transducteur piézoélectrique sous la forme d'une couche mince de nitrure d'aluminium AIN déposée par pulvérisation cathodique sur un substrat sous forme de plaquette de silicium ou d'arséniure de gallium avec interposition soit d'une membrane d'air, soit de couches de matériaux quart d'onde, afin d'isoler acoustiquement le transducteur du substrat de plaquette.

Le document décrit également la possibilité de coupler par des modes de vibrations longitudinaux une couche de silice (SiO2) au transducteur piézoélectrique afin de stabiliser sa dérive de fréquence en température.

Toutefois, en raison de la qualité acoustique moyenne de l'ensemble formé par le transducteur piézoélectrique et la couche de silice, le problème de la présence d'une dérive thermique de la fréquence demeure et la solution proposée n'est pas convaincante quant à la compensation des effets thermiques du second ordre.

Le document intitulé « High Overtone Bulk Acoustic Resonators built using Aluminium Nitride Thin flms deposited onto AT-cut quartz plates " de S. Bal-landras et al. publié dans 2006 IEEE Frequency Control Symposium, décrit une couche d'aluminium nitruré enserrée dans deux électrodes et collée par l'une des électrodes à un substrat de quartz classique. Le document indique que le mode couplé par effet piézoélectrique dans le nitrure d'aluminium est longitudinal et par voie de conséquence, le mode de propagation dans le quartz sous-jacent présente la même polarisation.

Le document US 3 401 275 décrit un résonateur piézoélectrique.

En raison de la mauvaise qualité de la stabilité en température des ondes longitudinales dans le quartz, la stabilité en température des fréquences est de mauvaise qualité, la dérive linéaire dépassant 20 ppm en valeur absolue à température ambiante. Le problème de la présence d'une dérive thermique de la fréquence demeure par conséquent et ne permet pas à ce type de solution, bien que bénéficiant de produit coefficient de qualité acoustique fréquence de travail (QF) notablement élevé (QF de plus de $1,3.10^{13}$ à plus de 400 MHz), de supplanter les résonateurs à ondes de surface pour les applications de synthèse de fréquence embarquées par exemple.

L'invention a pour but d'améliorer la stabilité thermique en fréquence d'un résonateur acousto-électrique à fort couplage piézoélectrique et à produit coefficient de qualité fréquence d'utilisation élevé.

A cet effet l'invention a pour objet un résonateur de type à ondes de volume à modes harmoniques élevés HBAR destiné à travailler à une fréquence de travail prédéterminée selon la revendication 1.

Suivant des modes particuliers de réalisation, le résonateur de type HBAR comporte l'une ou plusieurs des caractéristiques récitées dans les revendications dépendantes 2 à 12.

L'invention a également pour objet un procédé de fabrication d'un résonateur HBAR selon la revendication 13.

L'invention a également pour objet un oscillateur homodyne comprenant un résonateur HBAR tel que défini ci-dessus.

L'invention a également pour objet un filtre à réjection élevée comprenant des cellules à base de résonateurs HBAR tels que définis ci-dessus.

L'invention sera mieux comprise à la lecture de la description d'une forme de réalisation qui va suivre, donnée uniquement à titre d'exemple et faite en se référant aux dessins sur lesquels :

- la figure 1 est une vue en perspective d'un résonateur HBAR selon l'invention
- la figure 2 est une vue d'une coupe transversale du résonateur de la figure 2 selon la ligne II-II,
- la figure 3 est une vue de la représentation du premier angle de coupe θ1 du cristal formant le transducteur piézoélectrique,

- la figure 4 est une vue de l'évolution de la vitesse de phase des ondes de volume d'un cristal de niobate de lithium en fonction de l'angle de coupe θ1, cette famille d'orientations cristallines étant généralement appelée « coupes à simple rotation »,
- la figure 5 est une vue de l'évolution des coefficients de couplage de ces mêmes ondes pour le niobate de lithium en fonction de l'angle θ1,
- la figure 6 est une représentation planaire liée à la plaque du transducteur de la polarisation des ondes de cisaillement du transducteur,
- la figure 7 est une vue de la représentation du deuxième angle de coupe θ2 du cristal formant le substrat acoustique,
- la figure 8 une représentation planaire liée à la plaque du substrat acoustique de la polarisation des ondes de cisaillement du substrat acoustique,
- la figure 9 est un graphique de variation des coefficients de température de la fréquence du premier ordre à polarisation constante pour les modes de cisaillement du quartz en fonction de l'angle de coupe θ2.
- la figure 10 est un graphique de performance typique de stabilité en température de la fréquence dans la bande passante du résonateur de la figure 1 selon l'invention,
- la figure 11 est un ordinogramme d'un mode de réalisation du procédé de fabrication du résonateur décrit à la figure 2.

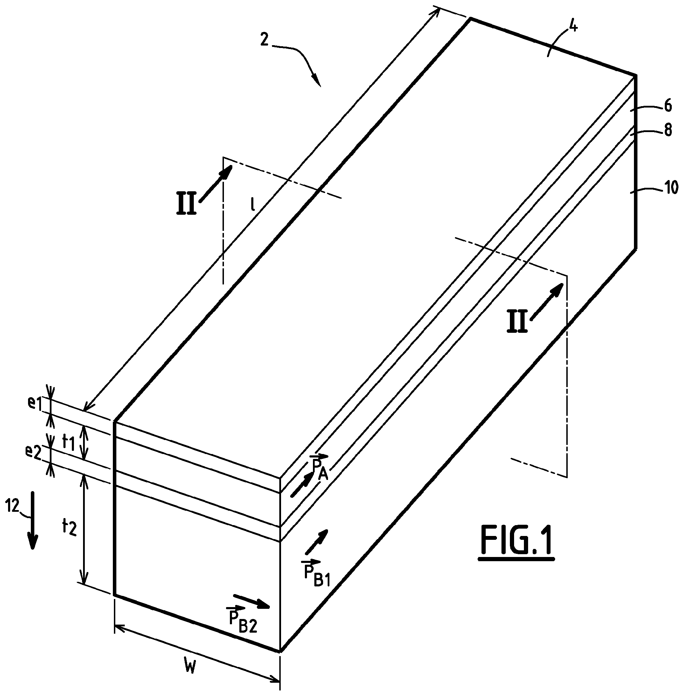

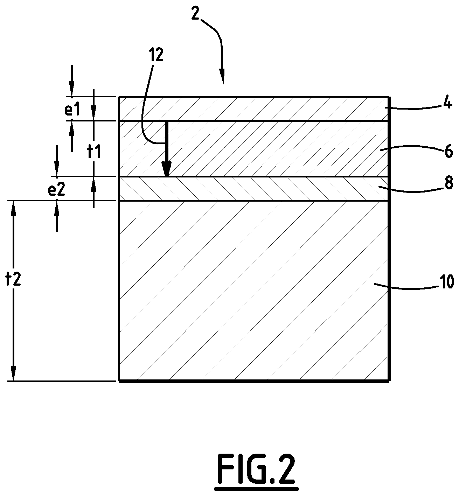

Les figures 1 et 2 représentent une forme de réalisation d'un résonateur 2 de type à ondes de volume à harmoniques élevées selon l'invention.

Le résonateur 2 comprend un empilement de couches successives comportant :

- une électrode supérieure 4 en aluminium d'épaisseur $e_1$,
- un transducteur piézoélectrique 6 constitué d'un premier matériau, ici du niobate de lithium (LiNbO3), sous forme monocristalline ayant une première épaisseur $t_1$,
- une contre-électrode 8 en or, enterrée d'épaisseur $e_2$,
- un substrat acoustique 10 constitué d'un deuxième matériau, ici du quartz, sous forme monocristalline ayant une deuxième épaisseur $t_2$.

Toutes les couches 4, 6, 8 et 10 présentent sur la figure 1 la même longueur l et la même largeur W, la longueur l étant nettement supérieure à la largeur W et aux différentes épaisseurs de couche $e_1$, $t_1$, $e_2$ et $t_2$.

Pour simplifier la figure 1, les électrodes 4, 8 sont représentées de surfaces égales à celles du transducteur piézoélectrique 6.

En pratique, les électrodes 4, 8 présentent des surfaces inférieures à celles de la couche piézoélectrique 6, et l'électrode supérieure 4 présente une surface inférieure ou égale à celle de la contre-électrode enterrée.

Dans le procédé de fabrication incluant une couche enterrée servant de couche de collage, la contre-électrode 8 présente naturellement une surface supérieure à celle de l'électrode supérieure 4 fabriquée par une technique de lithographie et de dépôt de couche métallique.

Les surfaces des électrodes 4, 8 sont disposées en vis-à-vis, parallèles entre elles, les zones respectives en regard des surfaces étant maximales, avec des bords les plus parallèles possible. Dans le cas idéal, les surfaces des électrodes 4, 8 sont superposées parfaitement.

Ainsi, l'excitation des ondes est supposée correspondre à une configuration dite de résonateur plan-plan pour laquelle les ondes sont excitées par les électrodes 4, 8 très minces déposées sur les surfaces en regard du transducteur piézoélectrique 6, dans le sens représenté par la flèche 12 selon la figure 2 de propagation des ondes de cisaillement dans le transducteur 6.

Le transducteur piézoélectrique 6 présente un mode de cisaillement excité selon une polarisation dirigée le long de la longueur L du résonateur représenté par le vecteur $\vec{P}_A$.

Le substrat acoustique 10 présente deux modes de cisaillement, un premier dit lent et un deuxième dit rapide.

Les ondes de cisaillement dites rapides et les ondes de cisaillement dites lentes sont définies comme des ondes de cisaillement de polarisation orthogonale, les ondes dites rapides ayant une vitesse de phase supérieure aux ondes dites lentes.

Sur la figure 1, le vecteur de polarisation $\vec{P}_A$ de l'excitation correspondant au mode de cisaillement du transducteur 6 est aligné avec un vecteur de polarisation référencé $\vec{P}_{B1}$ correspondant à un mode de cisaillement du substrat acoustique.

Un vecteur de polarisation correspondant au mode de cisaillement orthogonal à celui représenté par $\vec{P}_{B1}$ est représenté sur la figure 1 par $\vec{P}_{B2}$, orthogonal à $\vec{P}_{B1}$ et contenu dans un plan d'extension du substrat 10.

La contre-électrode 8 thermo-compressée entre le transducteur 6 et le substrat 10 sert en outre de colle à la structure du résonateur 2.

La couche de niobate de lithium (LiNbO3) constituant le transducteur 6 est une plaque découpée selon un premier angle de coupe θ1 dans un matériau brut monocristallin formant une tranche dénommée wafer en anglais.

La couche de quartz constituant le substrat acoustique 10 est une plaque découpée selon un deuxième angle de coupe θ2 dans une tranche de quartz monocristallin brut.

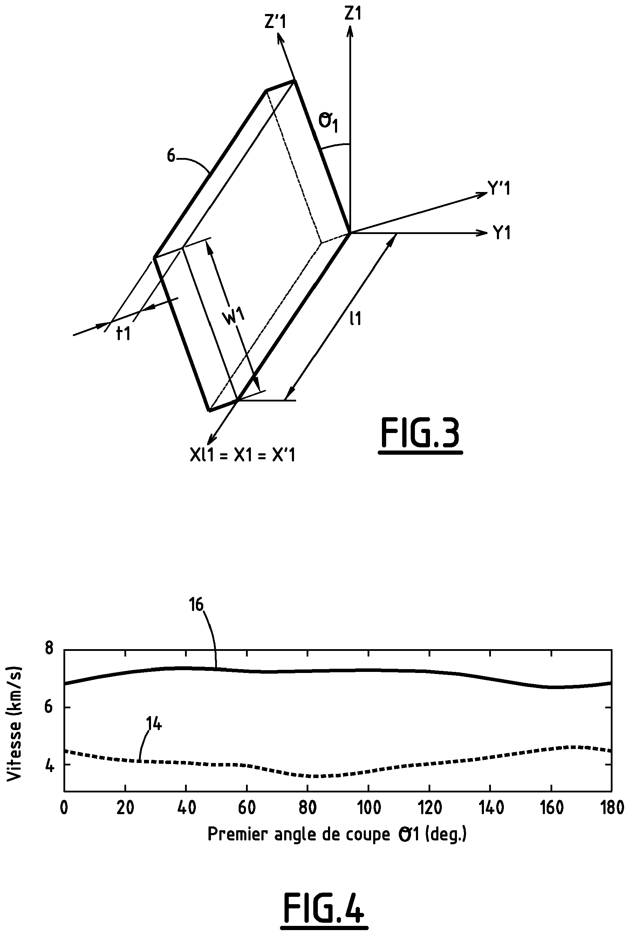

Selon la figure 3, la plaque de niobate de lithium 6 est découpée selon un premier angle de coupe θ1 à partir du matériau de la tranche non représentée mais repérée par ses axes cristallographiques $X_1$, $Y_1$, $Z_1$, l'axe $Z_1$ étant l'axe longitudinal de la tranche et les axes cristallographiques $X_1$, $Y_1$ étant prédéterminés lors de la fabrication du monocristal.

L'angle θ1 est ici celui défini dans le standard IEEE Std-176 (révision 1949) comme l'angle θ1 d'une coupe à simple rotation autour de l'axe cristallographique X1, la coupe étant notée $(Y_1 X_{l1})$ / θ1 dans le standard IEEE, $X_{l1}$ étant l'axe aligné sur le bord inférieur droit d'épaisseur $t_1$ de longueur $l_1$ selon la représentation de la figure 3.

Le repère lié à la plaque découpée 6 est représenté par les trois axes $X'_1$, $Y'_1$, $Z'_1$, l'axe $X'_1$ étant confondu avec l'axe X1. Les deux axes $Y'_1$, $Z'_1$ sont obtenus respectivement par la rotation d'angle θ1 des axes $X_1$, $Y_1$ autour de l'axe X1.

La figure 4 représente l'évolution de la vitesse de phase des ondes longitudinales et de cisaillement pour des coupes à simple rotation autour de l'axe cristallographique $X_{l1}$ du transducteur 6 pour le niobate de lithium.

La courbe 14 représente la vitesse de phase des ondes de cisaillement se propageant dans le transducteur 6 selon l'axe normal aux plans des électrodes 4 et 8, en fonction du premier angle θ1.

La courbe 16 représente la vitesse de phase des ondes longitudinales, exprimée en km/s, se propageant dans le transducteur 6 selon l'axe de la longueur I en fonction du premier angle de coupe θ1, exprimé en degrés.

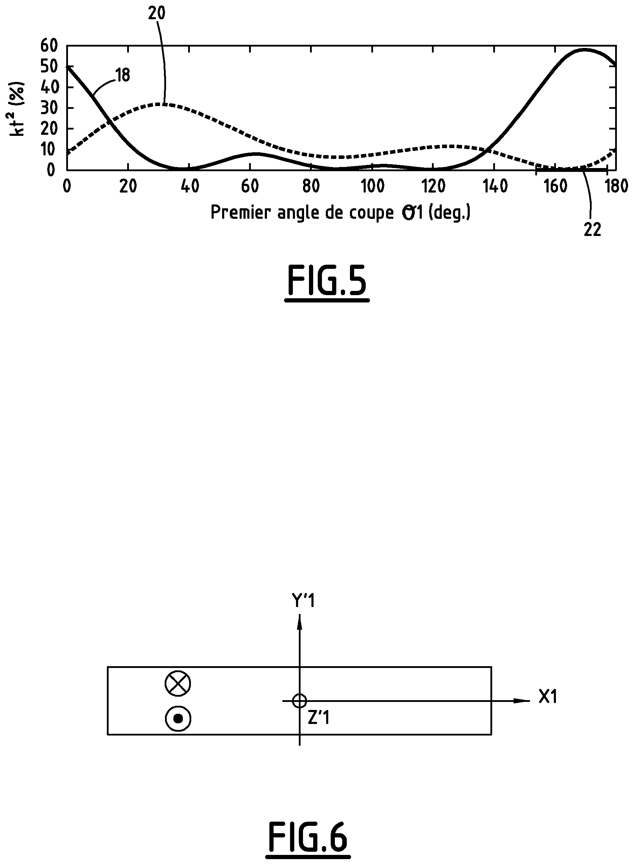

La figure 5 représente le couplage des ondes longitudinales et de cisaillement pour les coupes à simple rotation autour de l'axe cristallographique $X_1$ du transducteur 6.

La courbe 18 représente l'évolution du coefficient de couplage $K^2_T$ exprimée en pourcentage d'énergie électrique convertie en énergie acoustique pour des ondes de cisaillement en fonction du premier angle de couple θ1 exprimé en degrés.

La courbe 20 représente l'évolution du coefficient de couplage $K^2_T$ exprimée en pourcentage d'énergie électrique convertie en énergie acoustique pour des ondes longitudinales en fonction du premier angle de couple θ1 exprimé en degrés.

Il est visible sur la figure 5 que les courbes 18 et 20 présentent une zone angulaire 22 dans laquelle l'onde longitudinale n'est quasiment pas couplée par piézoélectricité et ne contribue donc pas à la réponse électrique du transducteur 6 et l'excitation de l'onde de cisaillement est particulièrement efficace avec un couplage électromécanique compris entre 50 et 60%.

La zone angulaire 22 est centrée autour de l'angle θ1 égal à 163° et d'amplitude égale à 10°.

L'angle de couple θ1 du transducteur décrit à la figure 1 est choisi dans la zone 22 de la figure 6 égal à 163°.

Pour les coupes de niobate de lithium à simple rotation, seul le mode correspondant à l'onde de cisaillement rapide présente un couplage électromécanique par piézoélectricité. En considérant la représentation planaire fournie à la figure 6 de la plaque du transducteur 6 selon les axes planaires $X'_1$, $Y'_1$, on montre que le mode de cisaillement excité par piézoélectricité présente une polarisation scalaire selon l'axe $Z'_1$ représenté de bout sur la figure 6 c'est à dire normal au plan $(X'_1, Y'_1)$ mais dont la dépendance spatiale est décrite par une fonction des coordonnées spatiales selon le plan d'excitation. Le vecteur de polarisation $\vec{P}_A$ est choisi colinéaire à l'axe $Z'_1$.

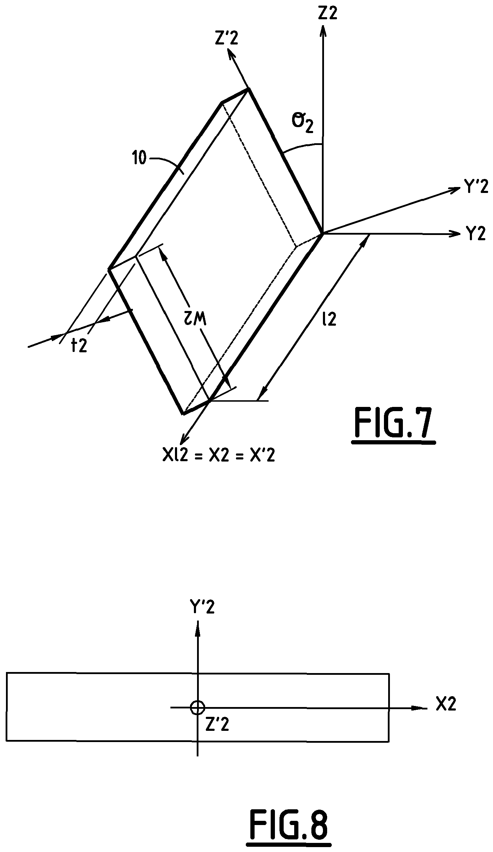

Selon la figure 7, la plaque de quartz 10 est découpée selon un deuxième angle θ2 à partir du monocristal brut de la tranche non représentée mais repérée par les axes cristallographiques du quartz $X_2$, $Y_2$, $Z_2$, l'axe $Z_2$ étant l'axe optique C révélé lors de la croissance d'une gemme de cristal.

L'angle θ2 est ici celui défini dans le standard IEEE Std-176 (révision 1949) comme l'angle θ2 d'une coupe à simple rotation autour de l'axe cristallographique $X_2$, la coupe étant notée $(Y_2, X_{l2})$ / θ2 dans le standard IEEE Std-176, $X_{l2}$ étant l'axe aligné sur le bord inférieur droit d'épaisseur $t_2$ de longueur $l_2$ selon la représentation de la figure 4.

Le repère lié à la plaque de quartz découpée 10 est représenté par les trois axes $X'_2$, $Y'_2$, $Z'_2$, l'axe $X'_2$ étant confondu avec l'axe X2. Les deux axes $Y'_2$, $Z'_2$ sont obtenus respectivement par la rotation d'angle θ2 des axes $Y_2$, $Z_2$ autour de l'axe X2.

En considérant la représentation planaire selon les axes planaires $X'_2$, $Y'_2$ fournie à la figure 8 de la plaque de quartz 10, analogue à la représentation planaire fournie pour le transducteur 6 à la figure 6, on peut décrire la polarisation du mode de cisaillement que l'on cherche à exploiter dans le quartz qui présente des coupes pour lesquelles les sensibilités thermiques du premier ordre voire du deuxième ordre s'annulent. Le cisaillement dans le cas du quartz est également scalaire mais s'établit selon l'axe $X'_2$ et dépend des coordonnées locales liées à la plaque selon le plan d'excitation. Pour des plaques de quartz et de niobate ou de tantalate de lithium à simple rotation notée (YXl/0) selon la notation standard 176 IEEE révision 1949 (IEEE Standard on piezoelectricity Std 176 -1949, Proc.of the IRE, vol. 37, pages 1378-1395, 1949), les ondes de cisaillement choisies présentent donc des polarisations orthogonales entre elles et ne se couplent que si les alignements des axes cristallographiques du transducteur 6 et du substrat acoustiques sont convenablement choisis. Il faut tenir compte de ces polarisations lors de l'assemblage des matériaux du transducteur et du substrat acoustique pour permettre le couplage des ondes acoustiques que l'on veut exciter dans le substrat acoustique 10 de propagation, ici le quartz.

Ici, cet effet de couplage acoustique est obtenu en alignant l'axe $Z'_1$ du transducteur 6 sur l'axe $X'_2$ du substrat acoustique 10, ou de manière équivalente en alignant l'axe $X'_1$ du transducteur 6 sur l'axe $Z'_2$ du substrat acoustique 10 , de sorte que la polarisation $\vec{P}_A$ du mode excité dans le transducteur 6 soit identique à celles de modes de cisaillement dans le substrat acoustique 10 représenté par $\vec{P}_{B1}$ permettant la compensation de la dérive thermique de la vitesse de phase des ondes correspondantes.

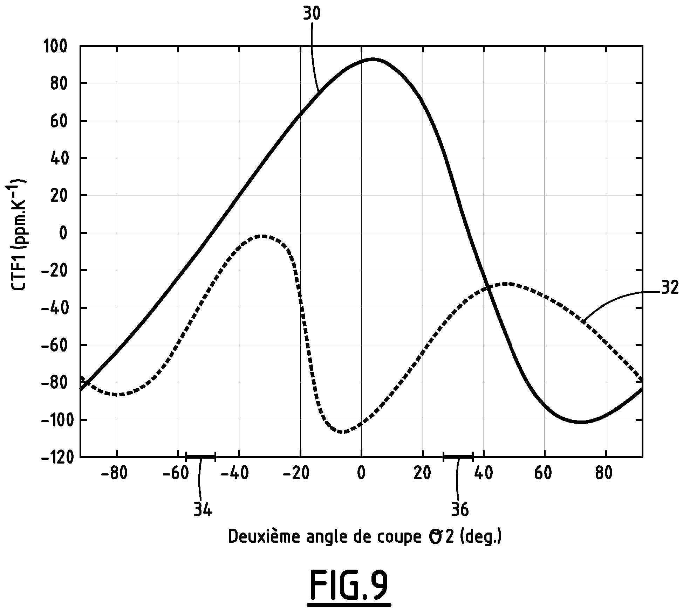

La figure 9 représente la sensibilité des modes de cisaillement du quartz aux effets thermiques statiques sous forme de deux coefficients de température de la fréquence du premier ordre CTFB1 et CTFB2 correspondant à des polarisations constantes orthogonales entre elles pour un substrat acoustique 10 plan-plan similaire à celui de la figure 1 exprimée en ppm.K$^{-1}$ (partie par millions de la fréquence par Kelvin), en fonction du deuxième angle de couple θ2 exprimé en degrés.

Une première courbe 30 en trait plein représente l'évolution du coefficient de température de la fréquence du premier ordre CTFB1 pour les ondes de cisaillement polarisées selon l'axe $X'_2$ en fonction du deuxième angle de coupe θ2, leur polarisation correspondant au vecteur $\vec{P}_{B1}$ sur la figure 1.

Une deuxième courbe 32 en trait pointillé représente l'évolution du coefficient de température de la fréquence du premier ordre CTFB2 pour les ondes de cisaillement polarisées de façon orthogonale aux précédentes en fonction du deuxième angle de coupe θ2, leur polarisation correspondant au vecteur $\vec{P}_{B2}$ sur la figure 1.

Les ondes de cisaillement dites rapides et les ondes de cisaillement dites lentes sont définies comme des ondes de cisaillement de polarisation orthogonale, les ondes dites rapides ayant une vitesse de phase supérieure aux ondes dites lentes.

Dans le cas du quartz, au voisinage de l'angle de coupe θ2 égal à -24 degrés, les deux modes lent et rapide échangent leur polarisation. Les modes restent orthogonaux mais le mode de cisaillement rapide se substitue au mode de cisaillement lent pour les coupes d'angle θ2 compris entre -24 et -90 degrés. Ce phénomène n'est pas visible sur la figure 9 du fait que les courbes 30 et 32 sont des représentations des CTFB à polarisation constante mais pas des représentations par type de mode rapide ou lent.

Pour θ2 compris entre -24 degrés et +90 degrés, les ondes polarisées suivant $X_2$ correspondent au mode de cisaillement lent alors que pour θ2 compris entre -90 degrés et -24 degrés, les ondes polarisées suivant $X_2$ correspondent au mode de cisaillement rapide.

La courbe 30 montre l'existence de deux zones angulaires 34, 36 dans chacune desquelles il existe une valeur angulaire notée respectivement θ2nul1 et θ2nul2 d'annulation du coefficient de température de la fréquence du premier ordre CTFB1 pour les ondes de cisaillement polarisées selon l'axe $X'_2$ .

Pour la zone 36, appelée également famille de coupes AT, des valeurs de coupe θ2 très précises peuvent être obtenues entre 35 degrés et 36 degrés permettant l'annulation du coefficient de température d'ordre 2, la dérive de la fréquence en fonction de la température suivant alors une loi d'évolution cubique.

Pour la zone 34, seul le coefficient du premier ordre peut s'annuler mais cette famille de coupes classique appelée BT est connue pour présenter des facteurs de qualité de résonance meilleurs que ceux accessibles avec la famille de coupes AT.

Dans le cas du quartz, θ2nul1 et θ2nul2 sont égaux à -42 degrés et à +35 degrés respectivement.

La première zone angulaire 34 centrée sur θ2nul1 présente une amplitude de 20 degrés, de préférence 10 degrés, pour laquelle la portion de courbe 30 peut être assimilée à un segment de droite de pente positive.

La deuxième zone angulaire 36 centrée sur θ2nul2 présente également une amplitude de 20 degrés, de préférence 10 degrés pour laquelle la portion de courbe 30 peut être assimilée à un segment de droite de pente négative.

Le premier angle de coupe θ1 du transducteur de la figure 1 est choisi dans la zone 22.

Le deuxième angle θ2 du substrat acoustique 10 est choisi dans la portion d'une des zones 34 ou 36 pour laquelle CTFB1 est nul ou positif en tenant compte du fait que le coefficient CTFA est négatif.

On décrit également le cas de la coupe AT, c'est-à-dire θ2 compris dans la zone 36 et de préférence égal à 35 degrés, pour des épaisseurs de niobate de lithium très inférieures à celles du quartz c'est-à-dire un rapport des épaisseurs niobate/quartz inférieur à 2%, les premiers modes suffisamment couplés pour être détectés sont parfaitement compensés des effets de température par le quartz. La sensibilité en température du résonateur notée CTFR du premier ordre est inférieure à 1 ppm.K$^{-1}$ pour des coefficients du deuxième ordre d'environ 1 ppb.K$^{-2}$.

Mais pour les modes présentant un couplage électromécanique maximal, il est observé un net accroissement de la valeur absolue de la sensibilité en température du premier ordre du résonateur. Ce phénomène est expliqué par le fait que l'énergie utile à l'excitation du mode est alors toujours plus grande dans la couche de niobate que dans le quartz jusqu'à atteindre un maximum pour une fréquence voisine de la vitesse des ondes couplées dans le niobate de lithium divisée par deux fois l'épaisseur de la couche de niobate, le mode correspondant au fondamental de la couche du transducteur seul. Le mode résultant dans le résonateur est alors plus sensible aux propriétés de la couche d'excitation formée par le transducteur et les électrodes que les modes dont l'énergie est principalement localisée dans la quartz. Toutefois la sensibilité en température du premier ordre du résonateur CTFR n'atteint pas les valeurs de sensibilité CTFA en température du premier ordre du transducteur seul, ce qui permet de minimiser la valeur de sensibilité du résonateur en jouant sur la coupe du quartz.

En considérant la valeur calculée de sensibilité en température du premier ordre du transducteur 6 seul, au voisinage de -90 ppm.K$^{-1}$ et la valeur de sensibilité du quartz quasiment à 0 ppm.K$^{-1}$, la valeur du CTFR du premier ordre résultante du résonateur pour le mode de couplage optimal peut être évaluée comme étant la somme pondérée des coefficients de température de la fréquence du premier ordre du transducteur et du substrat acoustique selon la formule :

$$CTFR = CTFB1(quartz) + CTFA(niobate)*Y(\%).$$

Le facteur Y exprimé en pourcentage vaut respectivement 6, 10, 15 pour les rapports d'épaisseurs niobate/quartz égaux à 1/50, 2,5/50 et 5/50, les épaisseurs étant de l'ordre des $\mu$m. Pour obtenir la compensation des effets de température du mode le plus fortement couplé, le CTFB1 du quartz doit être à peu près égal respectivement à +5, +10 et +15 ppm.K$^{-1}$.

On montre que pour des rapports d'épaisseurs Re niobate/quartz égaux à 10/50 et 20/50, les valeurs de Y sont de 22 et 32%.

La distribution du CTFR du mode au couplage le plus élevé en fonction de Re suit la loi suivante :

$$CTFR = 0,85xRe + 3,2xlog(4x50xRe),$$

dans laquelle

Re désigne le rapport de l'épaisseur du transducteur sur l'épaisseur du substrat acoustique, et
Log est la fonction logarithme népérien, les épaisseurs étant implicitement en $\mu$m et le CTFR étant exprimé en ppm.K$_{-1}$.

A partir de l'évolution du CTFB1 du quartz seul en fonction de l'angle de coupe $\theta2$ autour de l'axe X2 qui s'exprime au voisinage de $\theta2$ égal à +35 degrés (coupe AT) par la formule : CTFB1 = $(\theta2 - 35) *5.10^{-6}$, et de la formule distribution du CTFR, l'angle de coupe $\theta2$ corrigé noté $\theta2cor$ permettant la compensation des effets de température du mode le plus couplé, est déterminé par l'équation 0,85xRe + 3,2xlog(4x50xRe) = $(\theta2cor - 35) *5.10^{-6}$. Les coupes YXl/$\theta2$ avec un angle $\theta2$ égal à 34, 33, et 32 degrés sont utilisées d'après cette équation pour des rapports d'épaisseurs respectifs 1/50, 2,5/50 et 5/50. Ainsi, l'angle de coupe $\theta2$ est ajusté en fonction du rang harmonique du mode de couplage du résonateur et du rapport d'épaisseur niobate/quartz pour une coupe AT. La compensation de la dérive en température ainsi obtenue est du premier ordre et du deuxième ordre.

Si on remplace maintenant la coupe AT ($\theta2$ égal à 35 degrés) du quartz et ses proches voisines par la coupe BT (dans la zone 34 au voisinage de l'angle de coupe $\theta2$ égal à -48 degrés), un comportement similaire à celui de la coupe AT est observé.

Avec les premiers modes peu couplés, le CTFR du résonateur est égal parfaitement au CTFB1 du quartz, la compensation étant du premier ordre seulement dans le cas de la coupe BT.

Pour le mode à couplage maximal, le CTFR du résonateur est plus élevé et proche des CTFR observés pour la coupe AT. Les valeurs de CTFR du premier ordre du résonateur pour des rapports d'épaisseurs Re de 1/50, 2,5/50 et 5/50 sont respectivement égales à -6, -11 et -16 ppm.K$^{-1}$.

En reprenant la relation exprimant la valeur du CTFR du premier ordre résultante du résonateur pour le mode de couplage optimal comme la somme pondérée des coefficients de température de la fréquence du premier ordre du transducteur et du substrat acoustique selon la formule :
CTFR = CTFB1 (quartz) + CTFA(niobate)*Y(%), on trouve que Y vaut environ 7, 12, et 17 pour les rapport d'épaisseur Re respectifs de 1/50, 2,5/50 et 5/50, ce qui correspond à une progression analogue à celle observée pour la coupe AT.

A voisinage de la coupe BT ($\theta2$ égal à -42 degrés), l'évolution du CTFB1 du quartz est approchée avantageusement par la loi CTFB1 = $(\theta2 + 42) *2,2.10^{-6}$.

L'angle $\theta2$ corrigé des coupes YXl/02 est calculé comme devant être égal à -45, -43, et -41 degrés pour des rapports d'épaisseurs Re respectifs de 1/50, 2,5/50 et 5/50.

On montre également que la loi de distribution du CTF1 du mode le plus couplé du résonateur en fonction du rapport des épaisseurs niobate/quartz déterminée dans le cas de la coupe AT est applicable à une constante près dans la cas de la coupe BT. La loi s'écrit : CTFR = 1,25x50xRe + 3,2xlog(4x50xRe), ce qui permet de généraliser la procédure de conception lorsqu'il s'agit d'ajuster le rapport d'épaisseur Re niobate/quartz et l'angle de coupe $\theta2$ du quartz pour compenser le mode le mieux couplé des effets de température.

Les résultats obtenus ici sont transposables quelles que soient les épaisseurs des couches de niobate et de quartz. En particulier, si l'écart entre modes de résonance dépend de l'épaisseur totale de l'empilement formé par le transducteur et le substrat acoustique, seul le rapport des épaisseurs Re détermine le CTFR du premier ordre des modes de résonance en fonction de leur rang harmonique.

Ainsi, une structure de résonateur HBAR compensée en température peut être constituée pour laquelle les dimensions géométriques du transducteur sont définies de telle façon que le résonateur résonne à la fréquence d'accord souhaitée.

Les dimensions géométriques du transducteur sont définies de telle façon que le résonateur résonne à une fréquence d'accord souhaitée avec des caractéristiques électriques supplémentaires résultant d'exigences de fonctionnement d'une application.

Les caractéristiques électriques supplémentaires sont par exemple la séparation spectrale entre deux modes de résonnance définie comme la zone spectrale autour du mode de résonnance dépourvue d'autres résonances, l'efficacité de couplage électromécanique du mode de résonance sélectionné, l'impédance caractéristique à la résonance, le coefficient de qualité à la résonance et la stabilité thermique du mode de résonance.

La séparation spectrale permet de définir l'épaisseur totale de l'empilement des couches du résonateur HBAR puisque la séparation spectrale correspond à la fréquence du mode fondamental de l'ensemble formé par le transducteur et le substrat acoustique incluant l'électrode enterrée.

Les épaisseurs de chaque couche du résonateur HBAR formée de matériaux différents sont ajustées de sorte à obtenir un mode à la fréquence de résonance ou d'accord souhaitée.

L'épaisseur du transducteur piézoélectrique est déterminée également en tenant compte du couplage électromécanique souhaité. Le couplage est maximum lorsque le mode sélectionné est proche du mode fondamental de la résonance dans transducteur piézoélectrique seul.

Le rapport des épaisseurs transducteur/substrat acoustique est ajusté en fonction de la stabilité thermique recherchée et du coefficient de qualité de la résonance visée, sachant que pour atteindre de manière fiable la performance du paramètre de qualité à la résonance, il est nécessaire de bien connaître les constantes viscoélastiques des matériaux utilisés ou d'autres coefficients physiques à valeurs complexes représentatifs de propriétés physiques comme par exemple les constantes diélectriques. Les parties imaginaires de ces constantes sont souvent déterminées de façon heuristique ou par ajustement de paramètres de modèles prédictifs.

L'impédance à la résonance dépend du couplage électromécanique du mode sélectionné et de la valeur des surfaces d'électrodes en regard. Pour une impédance donnée par exemple 50 ohms, les surfaces en regard des électrodes seront d'autant plus grandes que le couplage électromécanique du mode sélectionné est faible.

Les surfaces d'électrodes type seront comprises entre quelques centaines de $\mu m^2$ et quelques $mm^2$ pour des épaisseurs d'empilement allant du mm à quelques $\mu m$.

Le couplage des vibrations électroacoustiques du transducteur 6 est effectué au travers de la contre-électrode 8 qui agit comme un court circuit acoustique dans la bande passante du transducteur 6.

Le substrat acoustique 10 asservit donc ainsi les modes de résonance du transducteur 6 sur ses propres modes de résonance et confère par là-même une forte stabilité en température aux modes de résonance du transducteur 6 qui laissés libres dériveraient fortement. En effet, les coefficients de température de la fréquence du premier ordre des transducteurs piézoélectriques HBAR présentent des valeurs élevées, par exemple entre -80 et -95ppm.K$^{-1}$ pour le niobate de lithium et -35 à -50 ppm.K$^{-1}$ pour le tantalate de lithium.

Ainsi, la stabilité en température des modes de résonance du transducteur 6 ainsi asservis est celle correspondant à la valeur du coefficient en température de fréquence CTFB1 sélectionnée au travers du deuxième angle de coupe $\theta2$ et de l'alignement des vecteurs de polarisation $\vec{P}_A$, $\vec{P}_{B1}$ correspondant respectivement au mode de cisaillement du transducteur 6 et du mode de cisaillement couplé du quartz 10, en tenant compte des lois d'ajustement d'angle de coupe $\theta2$, de rang d'harmonique du mode de résonance et de rapport d'épaisseur Re des matériaux transducteur/substrat acoustique du résonateur.

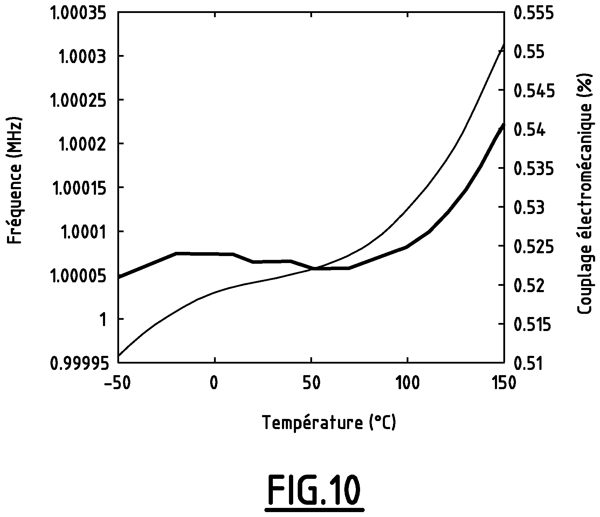

La figure 10 représente un exemple de performance de stabilité en température d'un résonateur selon l'invention.

Il apparaît sur la figure 8 que la température de fonctionnement nominal pour laquelle la dérive en fréquence du transducteur 6 est parfaitement compensée est égale à 50°C. Classiquement, la température de fonctionnement nominale d'un équipement électronique spatial est comprise entre 20 et 60°C.

La température de fonctionnement nominal du résonateur est réglable sans difficulté dans la gamme de températures s'étendant de -273°C à la température de Curie du quartz (+575°C).

En pratique, une gamme opérationnelle de températures est la gamme comprise depuis la température de l'hélium liquide ou de l'azote liquide (référence cryogénique) jusqu'à +400°C.

Bien que l'intégrité du collage aux températures extrêmes restent à valider, la robustesse d'un tel dispositif a été vérifiée aux basses températures correspondant à l'azote liquide et jusqu'à 200°C.

La variation de la fréquence de résonance ainsi que celle de la fréquence d'antirésonance indicative de la largeur de bande passante du résonateur est inférieure, ici sur la figure 8, à 1 ppm.K$^{-1}$.

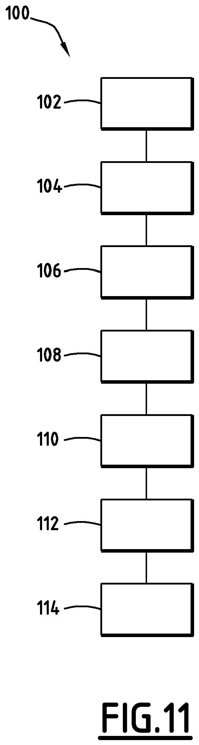

La figure 11 représente un ordinogramme d'un procédé de fabrication 100 d'un résonateur 2 de la figure 1 selon l'invention.

Dans une première étape 102, il est fourni un transducteur piézoélectrique 6 constitué par une couche d'une première épaisseur d'un premier matériau orienté selon un angle $\varphi$ défini par la nomenclature (YXw)/$\varphi$ du standard IEEE Std-176 (révision 1949) égal à zéro et coupé selon un premier angle de coupe $\theta 1$ défini par la nomenclature (YXl)/$\theta$ du standard IEEE Std-176 (révision 1949), tel que le couplage électroacoustique des ondes de cisaillement est supérieur à 5%, le transducteur 6 ayant un coefficient de température de la fréquence CTFA fonction du premier angle de coupe $\theta 1$.

Le matériau du transducteur 6 est compris dans l'ensemble des matériaux constitué par le nitrure d'aluminium (AIN), l'oxyde de zinc (ZnO), le niobate de lithium (LiNbO3), le tantalate de lithium (LiTaO$_3$) et le niobate de potassium.

De préférence, un matériau parmi le niobate de lithium (LiNbO$_3$) et le tantalate de lithium (LiTaO$_3$) sera choisi en raison d'une maitrise plus facile du processus de fabrication d'un monocristal d'une épaisseur significative.

Le niobate et le tantalate de lithium peuvent être fabriqués par tranche de diamètre 4" selon des standards d'épaisseur de 500 $\mu$m et 350 $\mu$m.

Dans une deuxième étape 104, il est fourni un substrat acoustique 10 constitué par une couche d'une deuxième épaisseur d'un deuxième matériau ayant un produit coefficient de qualité acoustique fréquence de travail au moins égal à $5.10^{12}$ , orienté selon un angle $\varphi$ défini par la nomenclature (YXw)/$\varphi$ du standard IEEE Std-176 (révision 1949) égal à zéro, coupé selon un deuxième angle de coupe $\theta 2$ défini par la nomenclature (YXl)/$\theta$ du standard IEEE Std-176 (révision 1949), présentant au moins une direction de polarisation $\vec{P}_{B1}$ correspondant à un mode de vibration de cisaillement, le substrat acoustique 10 ayant un coefficient de température de la fréquence du premier ordre correspondant à l'au moins un mode de cisaillement et dépendant du deuxième angle de coupe $\theta 2$,

Dans l'étape 104, le deuxième angle de coupe $\theta 2$ du substrat acoustique 10 est tel que le coefficient de température de la fréquence du premier ordre CTFB1 correspondant à l'au moins un mode de cisaillement et au deuxième angle de coupe $\theta 2$, est égal à l'opposé du coefficient de température de fréquence CTFA du transducteur 6 pondéré par une fonction croissante du rapport Re de l'épaisseur du transducteur 6 sur l'épaisseur du substrat acoustique 10, ce rapport étant supérieur ou égal à 0,02.

Le matériau du substrat acoustique est compris dans l'ensemble des matériaux constitué par le quartz et substituts isomorphes de type par exemple le GeO$_2$ et le TeO$_2$ , l'orthophosphate de gallium (GaPO$_4$) également de structure isomorphe, le niobate de potassium, le tétraborate de lithium (LiB$_4$O$_7$), la langasite (La$_3$Ga$_5$SiO$_{14}$), le langatate et la langanite et leurs différentes variantes.

De préférence, le matériau du substrat acoustique est du quartz en raison de ses remarquables propriétés de stabilité en température et de sa parfaite connaissance dans le domaine de la cristallographie.

Dans une étape suivante 106, une face du transducteur 6 et une face du substrat acoustique 10 sont métallisées selon une épaisseur comprise entre 100 à 200 nm par un métal thermo-compressible ou compressible à froid, par exemple de l'or, du cuivre ou de l'indium en vue de coller les deux faces et de former ainsi une contre-électrode.

L'or est un matériau particulièrement propice à ce genre de collage, compte tenu des ses propriétés plastiques et de sa robustesse mécanique suffisante pour assurer une liaison acoustique entre le transducteur 6 et le substrat acoustique 10.

A l'étape 108 d'assemblage, le transducteur 6 et le substrat acoustique 10 sont disposés de telle sorte que la direction de polarisation $\vec{P}_A$ du mode de cisaillement du transducteur 6 correspondant au premier angle de coupe $\theta 1$ et la direction de polarisation $\vec{P}_{B1}$ de l'au moins un mode de cisaillement du substrat 10 correspondant au deuxième angle de coupe $\theta 2$ sont alignées,

Dans une étape suivante 110, le collage est effectué par compression avec élévation de température ou non selon le métal utilisé.

Dans le cas de l'utilisation de l'or, la phase de chauffage est éliminée et un pressage de longue durée est mis en oeuvre mettant à profit les qualités de surface en regard et la ductilité du matériau métallique pour assurer le collage.

Ainsi, plusieurs plaquettes composites niobate de lithium/ quartz ont pu être réalisées de cette manière sans défaut en se contentant de maintenir une température de 30° C durant les 16 heures d'application d'une pression de 3000 Newtons.

Ensuite, dans une étape 112, la plaquette du résonateur est rodée et polie.

Puis, dans une étape 114, une électrode est métallisée, par de l'aluminium par exemple, sur une face du transducteur 6 opposée au substrat.

Le procédé est simple à mettre en oeuvre et permet d'obtenir de très bonnes performances de stabilité en température.

En outre, les résonateurs obtenus par ce procédé peuvent fonctionner jusqu'à des fréquences de 20 GHz. Les résonateurs sont légers et peu encombrants, et offrent un niveau d'intégration élevé.

Un tel résonateur peut par exemple être intégré dans un oscillateur homodyne ou dans des cellules d'un filtre à réjection élevée.

Bien entendu d'autres applications peuvent être envisagées.

## Revendications

1. Résonateur de type à ondes de volume à modes harmoniques élevés HBAR destiné à travailler à une fréquence de travail prédéterminée comprenant :

   un transducteur piézoélectrique (6) constitué par une couche d'une première épaisseur d'un premier matériau orienté selon un angle φ défini par la nomenclature (YXw)/φ du standard IEEE Std-176 (révision 1949) égal à zéro, coupé selon un premier angle de coupe θ1 défini par la nomenclature (YXl)/θ du standard IEEE Std-176 (révision 1949), tel que le couplage électroacoustique des ondes de cisaillement pour ce matériau seul est supérieur à 5%, le transducteur ayant un coefficient de température de la fréquence du premier ordre CTFA fonction du premier angle de coupe θ1,
   un substrat acoustique (10) constitué par une couche d'une deuxième épaisseur d'un deuxième matériau ayant un produit coefficient de qualité acoustique fréquence de travail au moins égal à $5.10^{12}$, orienté selon un angle φ défini par la nomenclature (YXw)/φ du standard IEEE Std-176 (révision 1949) égal à zéro, coupé selon un deuxième angle de coupe θ2 défini par la nomenclature (YXl)/θ du standard IEEE Std-176 (révision 1949), présentant au moins une direction de polarisation $\vec{P}_{B1}$ correspondant à un mode de vibration de cisaillement, le substrat acoustique (10) ayant un coefficient de température de la fréquence du premier ordre CTFB1 correspondant à l'au moins un mode de cisaillement et dépendant du deuxième angle de coupe θ2,
   une contre-électrode (8) formé par une couche de métal collant une première face du transducteur (6) et une face du substrat acoustique (10), et
   une électrode supérieure (4) disposée sur une deuxième face du transducteur (6) opposée à la première face du transducteur (6) et le substrat (10),
   **caractérisé en ce que**
   la disposition relative du transducteur (6) et du substrat (10) est telle que la direction de polarisation $\vec{P}_A$ du mode de cisaillement du transducteur (6) correspondant au premier angle de coupe θ1 et la direction de polarisation $\vec{P}_{B1}$ de l'au moins un mode de cisaillement du substrat (10) correspondant au deuxième angle de coupe θ2 sont alignées,
   le rapport Re de l'épaisseur du transducteur piézoélectrique sur l'épaisseur du substrat acoustique est supérieur ou égal à 0,02, et
   le deuxième angle de coupe θ2 du substrat (10) est tel que le coefficient de température de la fréquence du premier ordre CTFB1 correspondant à l'au moins un mode de cisaillement et au deuxième angle de coupe θ2 est égal à l'opposé du coefficient de température de fréquence CTFA du transducteur (6) pondéré par une fonction croissante du rapport Re, le deuxième angle de coupe θ2 vérifiant une relation de la forme :

$$\alpha.Re + \beta.\log(\gamma.Re) = (\theta2 - \theta2nul) *pente,$$

   θ2nul étant une valeur de deuxième angle de coupe pour laquelle le coefficient de température de la fréquence du premier ordre CTFB1 s'annule en changeant de signe,
   pente étant la pente de CTFB1 par rapport à θ2 prise en θ2nul,
   α, β et γ étant des constantes dépendant des matériaux constituant le substrat acoustique (10) et le transducteur (6), obtenues à partir de la loi suivante :

$$CTFR = \alpha.Re + \beta.\log(\gamma.Re)$$

   où CTFR représente une distribution de la sensibilité en température du résonateur dans le mode de couplage le plus élevé en fonction du rapport Re.

2. Résonateur de type HBAR selon la revendication 1, **caractérisé en ce que** le coefficient de température de la fréquence du deuxième ordre correspondant au deuxième angle de coupe θ2 pour lequel le coefficient de température de la fréquence du premier ordre CTFB1 s'annule en changeant de signe est également nul.

3. Résonateur de type HBAR selon l'une des revendications 1 ou 2, **caractérisé en ce que** le matériau du transducteur est compris dans l'ensemble des matériaux constitué par le nitrure d'aluminium, AIN, l'oxyde de zinc, ZnO, le niobate de lithium, LiNbO3, le tantalate de lithium, LiTaO3, et le niobate de potassium.

4. Résonateur de type HBAR selon la revendication 3, **caractérisé en ce que** le matériau du transducteur est compris de préférence dans l'ensemble des matériaux constitué par le niobate de lithium, LiNbO3, et le tantalate de lithium, LiTaO3.

5. Résonateur de type HBAR selon l'une des revendications 1 à 4, **caractérisé en ce que** le matériau du substrat acoustique est compris dans l'ensemble des matériaux constitué par le quartz, le niobate de potassium, l'orthophosphate de gallium, GaPO4, le tétraborate de lithium, LiB4O7, la langasite, La3Ga5SiO14, le langatate et la langanite.

6. Résonateur de type HBAR selon la revendication 5, **caractérisé en ce que** le matériau du substrat acoustique est du quartz.

7. Résonateur de type HBAR selon l'une des revendications 1 à 6, **caractérisé en ce que** la contre-électrode est un métal thermo-compressible.

8. Résonateur de type HBAR selon l'une des revendications 1 à 7, **caractérisé en ce que** la contre-électrode est constituée d'or ou de cuivre ou d'indium.

9. Résonateur de type HBAR selon la revendication 1 à 8, **caractérisé en ce que** les dimensions géométriques du résonateur sont adaptées pour une fréquence de résonnance d'une bande de fréquences comprise dans la gamme de fréquences allant de 50 MHz à 20 GHz.

10. Résonateur de type HBAR selon l'un des revendications 1 à 9, **caractérisé en ce que**
le substrat acoustique (10) présente une direction de polarisation pour laquelle le coefficient de température de la fréquence CTFB1 s'annule avec inversion de signe de part et d'autre en deux valeurs θ2nul1 et θ2nul2, la première valeur θ2nul1 étant associée à un mode de vibration de cisaillement lent et la deuxième valeur θ2nul2 étant associée à un mode de vibration de cisaillement rapide.

11. Résonateur de type HBAR selon la revendication 10, **caractérisé en ce que** le matériau du substrat acoustique (10) est du quartz.

12. Résonateur de type HBAR selon la revendication 11, **caractérisé en ce que** le matériau du transducteur (6) est du niobate de lithium et **en ce que** :

lorsque θ2nul est égal à +35 degrés,

a est égal à 0,85,
β est égal à 3,2
γ est égal à 200,
et pente est égal à $5.10^{-6}$,

lorsque θ2nul est égal à -42 degrés,

a est égal à 1,25x50
β est égal à 3,2
γ est égal à 200,
et pente est égal à $2,2.10^{-6}$ .

13. Procédé de fabrication d'un résonateur HBAR comprenant les étapes consistant à :

dans une première étape (102), fournir un transducteur piézoélectrique (6) constitué par une couche d'une première épaisseur d'un premier matériau orienté selon un angle φ défini par la nomenclature (YXw)/φ du standard IEEE Std-176 (révision 1949) égal à zéro et coupé selon un premier angle de coupe θ1 défini par la nomenclature (YXl)/θ du standard IEEE Std-176 (révision 1949), tel que le couplage électroacoustique des ondes de cisaillement est supérieur à 5%, le transducteur (6) ayant un coefficient de température de la fréquence CTFA fonction du premier angle de coupe θ1,

dans une deuxième étape (104), fournir un substrat acoustique (10) constitué par une couche d'une deuxième épaisseur d'un deuxième matériau ayant un produit coefficient de qualité acoustique fréquence de travail au moins égal à $5.10^{12}$ , orienté selon un angle φ défini par la nomenclature (YXw)/φ du standard IEEE Std-176 (révision 1949) égal à zéro, coupé selon un deuxième angle de coupe θ2 défini par la nomenclature (YXl)/θ du standard IEEE Std-176 (révision 1949), présentant au moins une direction de polarisation $\vec{P}_{B1}$ correspondant à un mode de vibration de cisaillement, le substrat acoustique (10) ayant un coefficient de température de la fréquence du premier ordre correspondant à l'au moins un mode de cisaillement et dépendant du deuxième angle de coupe θ2,

le rapport Re de l'épaisseur du transducteur piézoélectrique sur l'épaisseur du substrat acoustique étant supérieur ou égal à 0,02,

le deuxième angle de coupe θ2 du substrat acoustique (10) étant tel que le coefficient de température de la fréquence du premier ordre CTFB1 correspondant à l'au moins un mode de cisaillement et au deuxième angle de coupe θ2 est égal à l'opposé du coefficient de température de fréquence CTFA du transducteur (6) pondéré par une fonction croissante du rapport Re, le deuxième angle de coupe θ2 vérifiant une relation de la forme :

$$\alpha.Re + \beta.\log(\gamma.Re) = (\theta2 - \theta2nul) \ *pente,$$

θ2nul étant une valeur de deuxième angle de coupe pour laquelle le coefficient de température de la fréquence du premier ordre CTFB1 s'annule en changeant de signe,

pente étant la pente de CTFB1 par rapport à θ2 prise en θ2nul,

$\alpha$, $\beta$ et $\gamma$ étant des constantes dépendant des matériaux constituant le substrat acoustique (10) et le transducteur (6), obtenues à partir de la loi suivante :

CTFR= $\alpha$.Re + $\beta$.log($\gamma$.Re), où CTFR représente une distribution de la sensibilité en température du résonateur dans le mode de couplage le plus élevé en fonction du rapport Re,

et

dans une étape (108) d'assemblage, disposer le transducteur (6) et le substrat acoustique (10) de telle sorte que la direction de polarisation $\vec{P}_A$ du mode de cisaillement du transducteur (6) correspondant au premier angle de coupe θ1 et la direction de polarisation $\vec{P}_{B1}$ de l'au moins un mode de cisaillement du substrat (10) correspondant au deuxième angle de coupe θ2 sont alignées.

14. Oscillateur homodyne comprenant un résonateur HBAR défini selon l'une des revendications 1 à 12.

15. Filtre à réjection élevée comprenant des cellules à base de résonateurs HBAR définis selon l'une des revendications 1 à 12.

**Patentansprüche**

1. Resonator vom Typ für Volumenwellen mit harmonischen erhöhten Moden HBAR, welcher dazu bestimmt ist, bei einer vorbestimmten Arbeitsfrequenz zu arbeiten, und welcher aufweist:

einen piezoelektrischen Wandler (6), der gebildet ist aus einer Schicht mit einer ersten Dicke aus einem ersten Material, welches entlang eines Winkels φ gleich Null orientiert ist, welcher definiert ist mittels der Nomenklatur (YXw)/φ des Standards IEEE Std-176 (Revision 1949), und welches entlang eines ersten Schnittwinkels θ1, welcher definiert ist mittels der Nomenklatur (YXl)/θ des Standards IEEE Std-176 (Revision 1949), geschnitten ist, sodass die elektroakustische Kopplung von Scherwellen für dieses einzelne Material größer als 5% ist, wobei der Wandler einen Temperatur-Koeffizienten der Frequenz der ersten Ordnung CFTA abhängig vom ersten Schnittwinkel θ1 hat,

ein akustisches Substrat (10), welches aus einer Schicht mit einer zweiten Dicke aus einem zweiten Material gebildet ist, welches ein Akustische-Güte-Koeffizient-Arbeitsfrequenz-Produkt von mindestens gleich $5.10^{12}$ hat, entlang eines Winkels φ gleich Null, welcher definiert ist mittels der Nomenklatur (YXw)/φ des Standards

IEEE Std-176 (Revision 1949), orientiert ist, entlang eines zweiten Schnittwinkels θ2, welcher definiert ist mittels der Nomenklatur (YXI)/θ des Standards IEEE Std-176 (Revision 1949), geschnitten ist und welches mindestens eine Polarisationsrichtung $\vec{P}_{B1}$ hat, die zu einer Scherschwingung-Mode korrespondiert, wobei das akustische Substrat (10) einen Temperatur-Koeffizienten der Frequenz der ersten Ordnung CTFB1 hat, welcher zur mindestens einen Schermode korrespondiert und vom zweiten Schnittwinkel θ2 abhängig ist,

eine Gegenelektrode (8), die aus einer Metallschicht gebildet ist, welche eine erste Fläche des Wandlers (6) und eine Fläche des akustischen Substrats (10) verklebt, und

eine obere Elektrode (4), welche an einer zweiten Fläche des Wandlers (6) angeordnet ist, welche der ersten Fläche des Wandlers (6) und dem Substrat (10) gegenüberliegt,

**dadurch gekennzeichnet, dass**

die relative Anordnung des Wandlers (6) und des Substrats (10) derart ist, dass die Polarisationsrichtung $\vec{P}_A$ der Schermode des Wandlers (6), die zum ersten Schnittwinkel θ1 korrespondiert, und die Polarisationsrichtung $\vec{P}_{B1}$ der mindestens einen Schermode des Substrats (10), die zum zweiten Schnittwinkel θ2 korrespondiert, ausgerichtet sind,

das Verhältnis Re der Dicke des piezoelektrischen Wandlers über der Dicke des akustischen Substrats größer oder gleich 0,02 ist, und

der zweite Schnittwinkel θ2 des Substrats (10) derart ist, dass der Temperatur-Koeffizient der Frequenz der ersten Ordnung CTFB1, der zur mindestens einen Schermode und zum zweiten Schnittwinkel θ2 korrespondiert, gleich ist zum Negativen des Temperatur-Koeffizienten einer Frequenz CTFA des Wandlers (6), der gewichtet ist mittels einer steigenden Funktion des Verhältnisses Re, wobei der zweite Schnittwinkel θ2 eine Relation der Form erfüllt:

$$\alpha.\,\mathrm{Re} + \beta.\log(\gamma.\,\mathrm{Re}) = (\theta2 - \theta2\mathrm{nul})\ ^*\mathrm{pente},$$

wobei θ2nul ein Wert des zweiten Schnittwinkels ist, für welchen der Temperatur-Koeffizient der Frequenz der ersten Ordnung CTFB1 beim Vorzeichenwechsel zu Null wird,

pente die Steigung von CTFB1 bezüglich θ2 genommen bei θ2nul ist,

α, β und γ Konstanten sind, die von den Materialen abhängen, welche das akustische Substrat (10) und den Wandler (6) bilden, die erlangt werden ausgehend von dem folgenden Gesetz:

$$\mathrm{CTFR} = \alpha.\,\mathrm{Re} + \beta.\log(\gamma.\,\mathrm{Re}),$$

wobei CTFR eine Verteilung der Temperatur-Empfindlichkeit des Resonators in der Kopplungsmode darstellt, die abhängig von dem Verhältnis Re am meisten erhöht ist.

2. Resonator vom Typ HBAR gemäß Anspruch 1, **dadurch gekennzeichnet, dass** der Temperatur-Koeffizient der Frequenz der zweiten Ordnung, der zu dem zweiten Schnittwinkel θ2, für welchen der Temperatur-Koeffizient der Frequenz der ersten Ordnung CTFB1 beim Vorzeichenwechsel zu Null wird, korrespondiert, gleichermaßen null ist.

3. Resonator vom Typ HBAR gemäß Anspruch 1 oder 2, **dadurch gekennzeichnet, dass** das Material des Wandlers enthalten ist in der Gruppe von Materialien, die gebildet ist aus Aluminiumnitrid, AlN, Zinkoxid, ZnO, Lithiumniobat, LiNbO3, Lithiumtantalat, LiTaO3, und Kaliumniobat.

4. Resonator vom Typ HBAR gemäß Anspruch 3, **dadurch gekennzeichnet, dass** das Material des Wandlers vorzugsweise enthalten ist in der Gruppe von Materialien, die gebildet ist aus Lithiumniobat, LiNbO3, und Lithiumtantalat, LiTaO3.

5. Resonator vom Typ HBAR gemäß einem der Ansprüche 1 bis 4,
**dadurch gekennzeichnet, dass** das Material des akustischen Substrats enthalten ist in der Gruppe von Materialien, die gebildet ist aus Quarz, Kaliumniobat, Gallium-Orthophosphat, GaPO4, Lithium-Tetraborat, LiB4O7, Langasit, La3Ga5SiO14, Langatat und Langanit.

6. Resonator vom Typ HBAR gemäß Anspruch 5, **dadurch gekennzeichnet, dass** das Material des akustischen Substrats aus Quarz ist.

7.  Resonator vom Typ HBAR gemäß einem der Ansprüche 1 bis 6,
    **dadurch gekennzeichnet, dass** die Gegenelektrode ein thermokompressibles Material ist.

8.  Resonator vom Typ HBAR gemäß einem der Ansprüche 1 bis 7,
    **dadurch gekennzeichnet, dass** die Gegenelektrode aus Gold oder aus Kupfer oder aus Indium gebildet ist.

9.  Resonator vom Typ HBAR gemäß einem der Ansprüche 1 bis 8,
    **dadurch gekennzeichnet, dass** die geometrischen Abmessungen des Resonators angepasst sind für eine Resonanzfrequenz eines Frequenzbandes, welches in dem Frequenzbereich, der von 50 MHz bis 20 GHz geht, enthalten ist.

10. Resonator vom Typ HBAR gemäß einem der Ansprüche 1 bis 9,
    **dadurch gekennzeichnet, dass**
    das akustische Substrat (10) eine Polarisationsrichtung hat, wobei der Temperatur-Koeffizient der Frequenz CTFB1 mit Vorzeichenumkehr auf beiden Seiten in zwei Werten $\theta 2nul1$ und $\theta 2nul2$ zu Null wird, wobei der erste Wert $\theta 2nul1$ mit einer langsamen Scherschwingung-Mode assoziiert ist und der zweite Wert $\theta 2nul2$ mit einer schnellen Scherschwingung-Mode assoziiert ist.

11. Resonator vom Typ HBAR gemäß Anspruch 10, **dadurch gekennzeichnet, dass** das Material des akustischen Substrats (10) aus Quarz ist.

12. Resonator vom Typ HBAR gemäß Anspruch 11, **dadurch gekennzeichnet, dass** das Material des Wandlers (6) aus Lithiumniobat ist, und dadurch, dass:

    wenn $\theta 2nul$ gleich +35 Grad ist,

    $\alpha$ gleich 0,85 ist,
    $\beta$ gleich 3,2 ist
    $\gamma$ gleich 200 ist,
    und pente gleich $5.10^{-6}$ ist,

    wenn $\theta 2nul$ gleich -42 Grad ist,

    $\alpha$ gleich 1,25x50 ist,
    $\beta$ gleich 3,2 ist
    $\gamma$ gleich 200 ist,
    und pente gleich $2,2.10^{-6}$ ist.

13. Verfahren zum Herstellen eines HBAR-Resonators, welches die Schritte aufweist, welche bestehen aus:

    in einem ersten Schritt (102), Bereitstellen eines piezoelektrischen Wandlers (6), der gebildet ist aus einer Schicht mit einer ersten Dicke aus einem ersten Material, welches entlang eines Winkels $\varphi$ gleich null orientiert ist, welcher definiert ist mittels der Nomenklatur (YXw)/$\varphi$ des Standards IEEE Std-176 (Revision 1949), und welches entlang eines ersten Schnittwinkels $\theta 1$, welcher definiert ist mittels der Nomenklatur (YXl)/$\theta$ des Standards IEEE Std-176 (Revision 1949), geschnitten ist, sodass die elektroakustische Kopplung von Scherwellen größer als 5% ist, wobei der Wandler (6) einen Temperatur-Koeffizienten der Frequenz CFTA abhängig vom ersten Schnittwinkels $\theta 1$ hat,
    in einem zweiten Schritt (104), Bereitstellen eines akustischen Substrats (10), welches aus einer Schicht mit einer zweiten Dicke aus einem zweiten Material gebildet ist, welches ein Akustische-Güte-Koeffizient-Arbeitsfrequenz-Produkt von mindestens gleich $5.10^{12}$ hat, entlang eines Winkels $\varphi$ gleich Null orientiert ist, welcher definiert ist mittels der Nomenklatur (YXw)/$\varphi$ des Standards IEEE Std-176 (Revision 1949), entlang eines zweiten Schnittwinkels $\theta 2$, welcher definiert ist mittels der Nomenklatur (YXl)/$\theta$ des Standards IEEE Std-176 (Revision 1949), geschnitten ist, und welches mindestens eine Polarisationsrichtung $\vec{P}_{B1}$ hat, die zu einer Scherschwingung-Mode korrespondiert, wobei das akustische Substrat (10) einen Temperatur-Koeffizienten der Frequenz der ersten Ordnung hat, welcher zur mindestens einen Schermode korrespondiert und vom zweiten Schnittwinkel $\theta 2$ abhängig ist,
    wobei das Verhältnis Re der Dicke des piezoelektrischen Wandlers über der Dicke des akustischen Substrats größer oder gleich 0,02 ist,

wobei der zweite Schnittwinkel θ2 des akustischen Substrats (10) derart ist, dass der Temperatur-Koeffizient der Frequenz der ersten Ordnung CTFB1, der zur mindestens einen Schermode und zum zweiten Schnittwinkel θ2 korrespondiert, gleich ist zum Negativen des Temperatur-Koeffizienten einer Frequenz CTFA des Wandlers (6), der gewichtet ist mittels einer steigenden Funktion des Verhältnisses Re, wobei der zweite Schnittwinkel θ2 eine Relation der Form erfüllt:

$$\alpha.\,\mathrm{Re} + \beta.\log(\gamma.\,\mathrm{Re}) = (\theta2 - \theta2\mathrm{nul})\,{}^{*}\mathrm{pente},$$

wobei θ2nul ein Wert des zweiten Schnittwinkels ist, für welchen der Temperatur-Koeffizient der Frequenz der ersten Ordnung CTFB1 beim Vorzeichenwechsel zu Null wird,

pente die Steigung von CTFB1 bezüglich θ2 genommen bei θ2nul ist,

α, β und γ Konstanten sind, die von den Materialen abhängig sind, welche das akustische Substrat (10) und den Wandler (6) bilden, die erlangt werden ausgehend von dem folgenden Gesetz:

CTFR = α.Re + β.log(γ.Re), wobei CTFR eine Verteilung der Temperatur-Empfindlichkeit des Resonators in der Kopplungsmode darstellt, die abhängig von dem Verhältnis Re am meisten erhöht ist, und

in einem Schritt (108) des Montierens, Anordnen des Wandlers (6) und des akustischen Substrats (10), sodass die Polarisationsrichtung $\vec{P}_A$ der Schermode des Wandlers (6), die zum ersten Schnittwinkel θ1 korrespondiert, und die Polarisationsrichtung $\vec{P}_{B1}$ der mindesten einen Schermode des Substrats (10), die zum zweiten Schnittwinkel θ2 korrespondiert, ausgerichtet sind.

14. Homodyn-Oszillator, der einen HBAR-Resonator aufweist, der gemäß einem der Ansprüche 1 bis 12 definiert ist.

15. Filter mit erhöhter Unterdrückung, welches Zellen auf Basis von HBAR-Resonatoren, die gemäß einem der Ansprüche 1 bis 12 definiert sind, aufweist.

**Claims**

1. A resonator of the high bulk acoustic resonator type for operating at a predetermined working frequency, comprising:

a piezoelectric transducer (6) formed by a layer with a first thickness of a first material oriented along an angle φ defined by the nomenclature (YXw)/cp of the IEEE Std-176 (1949 revision) standard equal to zero, cut along a first cutting angle θ1 defined by the nomenclature (YX1)/θ of the IEEE Std-176 (1949 revision) standard, such that the electroacoustic coupling of the shear waves for that material alone is greater than 5%, the transducer having a temperature coefficient of the frequency of the first order CTFA as a function of the first cutting angle θ1,

an acoustic substrate (10) formed by a second layer with a second thickness of a second material having a functional frequency acoustic quality coefficient product at least equal to $5.10^{12}$, oriented along an angle φ defined by the nomenclature (YXw)/cp of the IEEE Std-176 (1949 revision) standard equal to zero, cut along a second cutting angle θ2 defined by the nomenclature (YX1)/θ of the IEEE Std-176 (1949 revision) standard, having at least one polarization direction $\vec{P}_{B1}$ corresponding to a shearing mode of vibration, the acoustic substrate (10) having a temperature coefficient of the frequency of the first order CTFB1 corresponding to the at least one shearing mode and depending on the second cutting angle θ2,

a counter-electrode (8) formed by a layer of metal adhering to a first face of the transducer (6) and a face of the acoustic substrate (10), and

an upper electrode (4) arranged on a second face of the transducer (6) facing away from the first face of the transducer (6) and the substrate (10),

**characterized in that**

the relative arrangement of the transducer (6) and the substrate (10) is such that the direction of polarization $\vec{P}_A$ of the shearing mode of the transducer (6) corresponding to the first cutting angle θ1 and the polarization direction $\vec{P}_{B1}$ of the at least one shearing mode of the substrate (10) corresponding to the second cutting angle θ2 are aligned,

the ratio Re of the thickness of the piezoelectric transducer over the thickness of the acoustic substrate is greater than or equal to 0.02, and

the second cutting angle θ2 of the substrate (10) is such that the temperature coefficient of the frequency of the first order CTFB1 corresponding to the at least one shear mode and to the second cutting angle θ2 is equal to the opposite of the temperature coefficient of frequency CTFA of the transducer (6) weighted by an increasing function of the ratio Re, the second cutting angle θ2 verifies a relationship of form:

$$\alpha.Re + \beta.\log(\gamma.Re) = (\theta2 - \theta2nul) *slope,$$

θ2nul being a second cutting angle value for which the temperature coefficient of the frequency of the first order CTFB1 cancels itself out and changes signs,
slope being the slope of CTFB 1 relative to θ2 taken in 02nul,
α, β and γ are constants depending on the materials making up the acoustic substrate (10) and the transducer (6), obtained by the following formula:

$$CTFR=\alpha.Re + \beta.\log(\gamma.Re),$$

where CTFR represents the distribution of the temperature sensitivity of the resonator at the highest coupling mode as a function of ratio Re.

2. The HBAR resonator according to claim 1, **characterized in that** the temperature coefficient of the frequency of the second order corresponding to the second cutting angle θ2 for which the temperature coefficient of the frequency of the first order CTFB 1 cancels itself out by changing signs is also zero.

3. The HBAR type resonator according to one of claims 1 or 2, **characterized in that** the material of the transducer is included in the group of materials made up of aluminum nitride AIN, zinc oxide ZnO, lithium niobate $LiNbO_3$, lithium tantalate $LiTaO_3$ and potassium niobate.

4. The HBAR type resonator according to claim 3, **characterized in that** the material of the transducer is preferably included in the group of materials made up of lithium niobate $LiNbO_3$ and lithium tantalate $LiTaO_3$.

5. The HBAR type resonator according to one of claims 1 to 4, **characterized in that** the material of the acoustic substrate is included in the group of materials made up of quartz, potassium niobate, gallium orthophosphate $GaPO_4$, lithium tetraborate $LiB_4O_7$, langasite $La_3Ga_5SiO_{14}$, langatate and langanite.

6. The HBAR type resonator according to claim 5, **characterized in that** the material of the acoustic substrate is quartz.

7. The HBAR type resonator according to one of claims 1 to 6, **characterized in that** the counter-electrode is a thermo-compressible metal.

8. The HBAR type resonator according to one of claims 1 to 7, **characterized in that** the counter-electrode is made of gold or copper or indium.

9. The HBAR type resonator according to claim 1 to 8, **characterized in that** the geometric dimensions of the resonator are adapted for a resonance frequency of a frequency band included in the frequency range from 50 MHz to 20 GHz.

10. The HBAR resonator according to one of claims 1 to 9, **characterized in that**
the acoustic substrate (10) has a polarization direction for which the temperature coefficient of the frequency CTFB1 cancels itself out with sign inversion on either side in two values θ2nul1 and θ2nul2, the first value θ2nul1 being associated with a slow shearing mode of vibration and the second value θ2nul2 being associated with a fast shearing mode of vibration.

11. The HBAR resonator according to claim 10, **characterized in that** the material of the acoustic substrate (10) is quartz.

12. The HBAR resonator according to claim 11, **characterized in that** the material of the transducer (6) is lithium niobate and **in that**:

when θ2nul is equal to +35 degrees,

$\alpha$ is equal to 0.85,
$\beta$ is equal to 3.2
$\gamma$ is equal to 200,
and slope is equal to $5.10^{-6}$,

when $\theta2nul$ is equal to -42 degrees,

$\alpha$ is equal to 1.25x50
$\beta$ is equal to 3.2
$\gamma$ is equal to 200,
and slope is equal to $2.2.10^{-6}$ .

13. A method for manufacturing a HBAR resonator comprising the following steps:

in a first step (102), providing a piezoelectric transducer (6) made up of a layer of a first thickness of a first material oriented along an angle $\varphi$ defined by the nomenclature (YXw)/cp of the IEEE Std-176 (1949 revision) standard equal to zero and cut along a first cutting angle $\theta1$ defined by the nomenclature (YX1)/$\theta$ of the IEEE Std-176 (1949 revision) standard, such that the electroacoustic coupling of the shear waves is greater than 5%, the transducer (6) having a temperature coefficient of the frequency CTFA as a function of the first cutting angle $\theta1$,

in a second step (104), providing an acoustic substrate (10) formed by a first layer with a second thickness of a second material having a functional frequency acoustic quality coefficient product at least equal to $5.10^{12}$, oriented along an angle $\varphi$ defined by the nomenclature (YXw)/cp of the IEEE Std-176 (1949 revision) standard equal to zero, cut along a second cutting angle $\theta2$ defined by the nomenclature (YX1)/$\theta$ of the IEEE Std-176 (1949 revision) standard, having at least one polarization direction $\vec{P}_{B1}$ corresponding to a shearing mode of vibration, the acoustic substrate (10) having a temperature coefficient of the frequency of the first order corresponding to the at least one shearing mode and depending on the second cutting angle $\theta2$,

the ratio Re of the thickness of the piezoelectric transducer over the thickness of the acoustic substrate is greater than or equal to 0.02,

the second cutting angle $\theta2$ of the acoustic substrate (10) being such that the temperature coefficient of the frequency of the first order CTFB1 corresponding to the at least one shearing mode and to the second cutting angle $\theta2$ is equal to the opposite of the frequency temperature coefficient CTFA of the transducer (6) weighted by an increasing function of the ratio Re,

the second cutting angle $\theta2$ verifying a relationship of form:

$$\alpha.Re + \beta.\log(\gamma.Re) = (\theta2 - \theta2nul) \, *slope,$$

$\theta2nul$ being a second cutting angle value for which the temperature coefficient of the frequency of the first order CTFB1 cancels itself out and changes signs,
slope being the slope of CTFB1 relative to $\theta2$ taken in $\theta2nul$,
$\alpha$, $\beta$ and $\gamma$ are constants depending on the materials making up the acoustic substrate (10) and the transducer (6), obtained by the following formula:

$$CTFR = \alpha.Re + \beta.\log(\gamma.Re),$$

where CTFR represents the distribution of the temperature sensitivity of the resonator at the highest coupling mode as a function of ratio Re,

and
in an assembly step (108), arranging the transducer (6) and the acoustic substrate (10) such that the polarization direction $\vec{P}_A$ of the shearing mode of the transducer (6) corresponding to the first cutting angle $\theta1$ and the polarization direction $\vec{P}_{B1}$ of the at least one shearing mode of the substrate (10) corresponding to the second cutting angle $\theta2$ are aligned.

14. A homodyne oscillator comprising a HBAR resonator defined according to one of claims 1 to 12.

**15.** A high reject filter comprising HBAR resonator-based cells as defined in claims 1 to 12.

## FIG.1

## FIG.2

## FIG.3

## FIG.4

20

18

$kt^2$ (%)

60
50
40
30
20
10
0

0      20     40     60     80     100    120    140    160    180

Premier angle de coupe σ1 (deg.)

22

## FIG.5

Y'1

X1

Z'1

## FIG.6

FIG.7

FIG.8

FIG.9

## FIG.10

100

102

104

106

108

110

112

114

## FIG.11

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

*   US 3401275 A

**Littérature non-brevet citée dans la description**

*   **M. LAKIN.** Thin Film Resonators and Filters. *IEEE Ultrasonics Symposium,* 1999
*   **S. BAL-LANDRAS et al.** High Overtone Bulk Acoustic Resonators built using Aluminium Nitride Thin flms deposited onto AT-cut quartz plates. *IEEE Frequency Control Symposium,* 2006
*   IEEE Standard on piezoelectricity Std 176 -1949. *Proc.of the IRE,* 1949, vol. 37, 1378-1395